# EUROPEAN PATENT APPLICATION

(11) **EP 0 601 200 A1**
(43) Date of publication of application: **15.06.1994**
(21) Application number: 93913518.2
(22) Date of filing: 14.06.1993
(51) Int. Cl.: H01L 27/146

(54) **SEMICONDUCTOR DEVICE**

(30) Priority: 15.06.1992 JP 181852/92; 22.06.1992 JP 188718/92; 30.06.1992 JP 197621/92; 30.06.1992 JP 197622/92; 30.06.1992 JP 197623/92; 30.06.1992 JP 197624/92
(71) Applicant: KANEGAFUCHI KAGAKU KOGYO KABUSHIKI KAISHA, Kita-ku Osaka-shi Osaka-fu 530 (JP)
(72) Inventor: KURATA, Sin-ichiro, Otsu-shi, Shiga 520 (JP); KOBAYASHI, Kenji, Otsu-shi, Shiga 520-01 (JP); ZENKI, Tomoyoshi, Settsu-shi, Osaka 566 (JP)
(74) Representative: VOSSIUS & PARTNER
(86) International application number: JP9300794
(87) International publication number: WO9326046

(57) **Abstract**

A semiconductor device for an original reader having a switching element such as a diode, an optical sensor element comprising a photoelectric conversion element and a switching element, and a switching element used in an image reader for inputting image information in a facsimile apparatus, an image scanner, and the like. In a semiconductor device (90) provided with a semiconductor element (blocking diode) (94) having a switching function and comprising a lower electrode (94a), a semiconductor layer (94b), an upper electrode (94c), all of which are formed vertically in this order; at least either one of the lower electrode (94a) and the upper electrode (94c) consists of one or more layers, and out of the conductive layers at least the one which is in contact with the semiconductor layer (94b) is transparent. An optical sensor element and an original document reader according to the present invention employ such semiconductor devices having switching function. In such a semiconductor device thus structured, the reverse direction current involved in switching elements such as blocking diodes and in optical sensor elements can be reduced, making it possible to enhance the switching speed, and to obtain exact signal output from the optical sensor element. Further, in an original document reader having these switching elements or optical sensor elements, inverted residual images can be reduced, and at the same time, the reading can be executed at a higher speed.

## Description

### Technical Field

This invention relates to a semiconductor device, and in particular to a semiconductor device fabricated on a glass substrate or the like, such as a switching element such as a diode, a photosensor element comprising a photoelectric energy converting element and a switching element, and a document reading device applied to an image reader or the like for inputting of image information in a facsimile device, image scanner or the like.

### Background Art

In recent years, document reading devices commonly known as contact-type image sensors have generally been widely employed for the image readers of facsimile devices, image scanners and so forth, instead of the CCD-type document reading device, for which reducing optics are necessary.

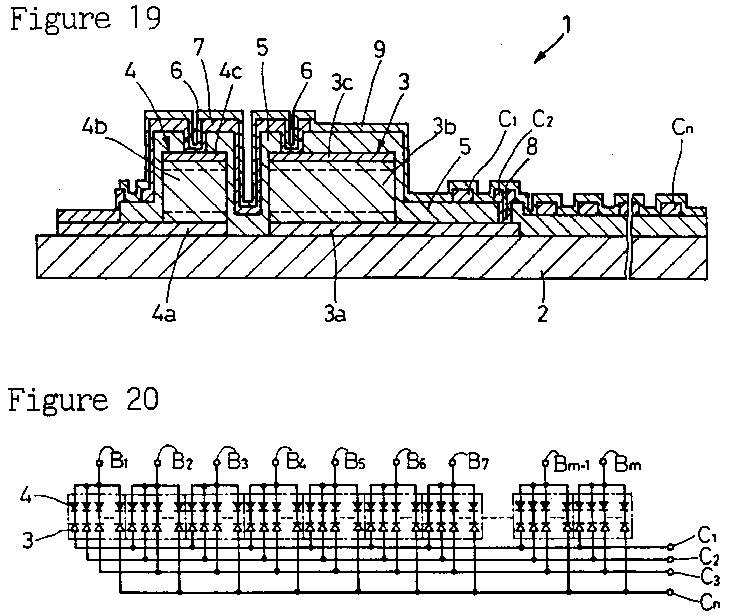

For example, as shown in Figure 19, a prior art document reading device 1 is formed by fabricating, on a glass substrate 2, photodiodes 3 which are photoelectric energy converting elements, blocking diodes 4 which are switching elements, and channel leads C₁, C₂,..., Cₙ for read-out of the electrical signals from the photodiodes 3.

The photodiode 3 and the blocking diode 4 are formed side by side by the sequential deposition of, respectively, opaque lower electrodes 3a, 4a made of metal, semiconductor layers 3b, 4b having a pin structure made of amorphous silicon, and transparent upper electrodes 3c, 4c made of ITO (Indium Tin Oxide). Furthermore, the photodiode 3 and the blocking diode 4 are covered with a transparent interlayer insulating film 5 made of SiOₓ, and are interconnected in series and opposite polarity using a coupling lead 7 through contact holes 6 formed in this interlayer insulating film 5. On the other hand, the lower electrode 3a constituting the photodiode 3 is connected to the respective channel lead C₁, C₂,..., Cₙ through a contact hole 8 fabricated in the interlayer insulating film 5. Moreover, this entire structure is covered with a protecting film 9. Here, the reason the upper electrode 4c of the blocking diode 4 is transparent is to simplify the manufacturing process by depositing it simultaneously with the upper electrode 3c of the photodiode 3.

Furthermore, as shown in Figure 20, these photodiodes 3 and blocking diodes 4 are divided every n diode pairs into m blocks, B₁, B₂,..., Bₘ, to form a one-dimensional array of m by n diode pairs, in which the anode electrodes of the blocking diodes 4 are connected commonly within each of the blocks B₁, B₂,..., Bₘ, and the anode electrodes of the photodiodes 3 in the same relative positions in the respective blocks B₁, B₂,..., Bₘ are connected together commonly using the respective channel leads C₁, C₂,..., Cₙ. It is required that the blocking diodes 4 select the photodiodes 3 of the respective blocks B₁, B₂,..., Bₘ in sequence.

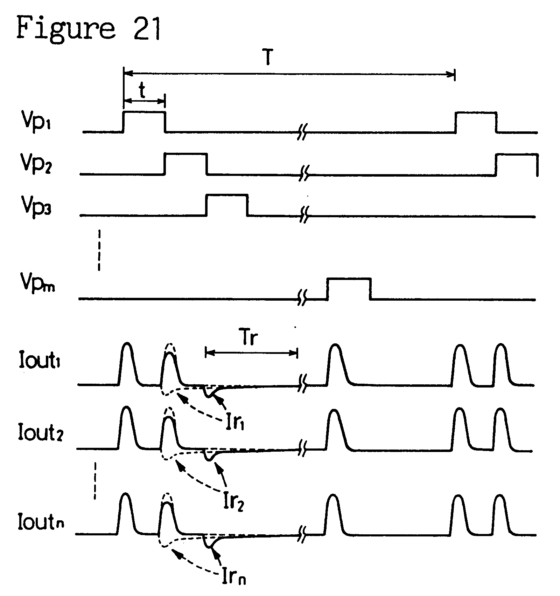

This document reading device 1 is based on a charge storage system for its operation. As shown in the time chart of Figure 21, drive pulses Vp₁, Vp₂,..., Vpₘ having a cycle T are applied to the respective blocks B₁, B₂,..., Bₘ in sequence. When this drive pulse Vp₁, Vp₂,..., Vpₘ is applied, the blocking diodes 4 in the respective block B₁, B₂,..., Bₘ become forward biased and the corresponding photodiodes 3 become reverse biased. This results in the rapid charging of the parallel capacitance of the photodiodes 3. This condition is the read-out state. On the other hand, at the time when the drive pulse Vp₁, Vp₂,..., Vpₘ is not applied, the blocking diodes 4 in the respective block B₁, B₂,..., Bₘ become reverse biased. Consequently, in between the pulses, when light enters into the photodiodes 3, the parallel capacitance of each photodiode 3 is discharged by a photocurrent generated in proportion to the amount of incident light. This condition is the storage state.

In other words, repetitions are carried out in which each individual block B₁, B₂,..., Bₘ is in the read-out state for a time t, and in the storage state for a time T-t. When a block B₁, B₂,..., Bₘ enters the read-out state, output currents Iout₁, Iout₂,..., Ioutₙ proportional to the amount of light which was incident during the storage state flow out along the respective channel leads C₁, C₂,..., Cₙ, and these output currents Iout₁, Iout₂,..., Ioutₙ are amplified and integrated using an external signal processing circuit, to become a time series output. For example, when the first block B₁ is in the read-out state, output currents Iout₁, Iout₂,..., Ioutₙ flow out from the first block B₁. Then the first block B₁ enters the storage state and the second block B₂ enters the read-out state, so that output currents Iout₁, Iout₂,..., Ioutₙ flow out from the second block B₂.

However, in practice, immediately after a block B₁, B₂,..., Bₘ switches from the read-out state to the storage state, a current (Below, given as "reverse direction current". Also known as "reverse direction recovery current".) Ir₁, Ir₂,..., Irₙ flows in the opposite direction to the output current Iout₁, Iout₂,..., Ioutₙ. The size of this reverse direction current Ir₁, Ir₂,..., Irₙ amounts to 10 to 20% of the normal output current Iout₁, Iout₂,..., Ioutₙ, and its converging time Tr reaches the order of 10⁻³ seconds. As a result of this, for example, in the case when the first block B₁ and the second block B₂ are reading white and the third block B₃ is reading black, the output current Iout₁, Iout₂,..., Ioutₙ flowing when the second block B₂ is in the read-out state is usually reduced by an amount equal to the respective reverse direction current Ir₁, Ir₂,..., Irₙ. Moreover, when the third block B₃ is in the read-out state, there should be no output current Iout₁, Iout₂,..., Ioutₙ, but in practice a reverse direction current Ir₁, Ir₂,..., Irₙ flows in the opposite direction.

In image reproduction, a phenomenon such as this is commonly known as a reverse after-image, because black which is read immediately after reading white appears blacker than the normal black, and white read immediately after reading black appears whiter than the normal white. In particular, in the case when white was read by the first block B₁ and grey (10 to 20% of the brightness of white) was read by the second block B₂, an accurate output signal was not obtained because the output currents Iout₁, Iout₂,..., Ioutₙ from the second block B₂ indicated black. Furthermore, in order to promote reduction of the electric power consumption, and so forth, there has been a trend to read manuscripts under a low illumination intensity; however, a problem was that even under low illumination intensity, the size of the reverse after-image was not reduced, and because only the size of the output signal was lowered, the relative proportion of the reverse after-image increased. In order to avoid the potential limitations of conditions such as this, it was necessary to prolong the duration t of the drive pulse Vp₁, Vp₂,..., Vpₘ; however, this gave the problem that the signal reading speed became slow.

Concerning the origin of this reverse direction current, it is considered that, even though the voltage on the blocking diodes 4 changes from forward bias to reverse bias, carriers injected at the time of the forward bias do not disappear immediately, and as a result there is a flow in the reverse direction for a certain time. In other words, it is considered that a limitation on the switching rate of the blocking diode 4 is incurred due to this reverse direction current.

Accordingly, the present inventors have, as a result of extensive studies, by reducing the reverse direction current accompanying a general switching element such as a blocking diode or a photosensor element containing this switching element, in order to both improve the switching rate and obtain an accurate signal output from the photosensor element, and moreover, in order to both reduce the reverse after-image and enable a higher reading speed in document reading devices having this kind of switching element or photosensor element, accomplished the present invention.

### Disclosure of the invention

An essential feature residing in the semiconductor device of the present invention is that the semiconductor device is provided with one or a plurality of a semiconductor element having a switching function, said semiconductor element comprising a lower electrode, a semiconductor layer and an upper electrode stacked in order, wherein at least one of the lower electrode and the upper electrode are formed from one or not less than two conductive layers, and at least the conductive layer contacting the semiconductor layer is formed from a transparent conductive layer.

In this kind of semiconductor device is provided one or a plurality of a photosensor element comprising the semiconductor element having the switching function connected in series with a photoelectric energy converting element formed from an upper electrode, a semiconductor layer and a lower electrode stacked in order.

Furthermore, in this kind of semiconductor device, the photosensor elements comprising the semiconductor element having the switching function connected in series with the photoelectric energy converting element formed from the upper electrode, the semiconductor layer and the lower electrode stacked in order, are arranged in a one-dimensional multiple array, wherein the photosensor elements are divided every fixed number of elements into a plurality of blocks, said photosensor elements being connected commonly on any one side within each of these blocks, and those in the same relative positions in the individual blocks being interconnected commonly on the other side using the respective channel leads.

Moreover, with this kind of semiconductor device, in the semiconductor device provided with at least one or a plurality of the above-mentioned semiconductor element having the switching function, at least one of the lower electrode and the upper electrode of the semiconductor element are formed from a transparent conductive layer.

Furthermore, with this kind of semiconductor device, in the semiconductor device provided with at least one or a plurality of the above-mentioned semiconductor element having the switching function, the transparent conductive layer of the semiconductor element is made of ITO.

Moreover, with this kind of semiconductor device, in the semiconductor device provided with at least one or a plurality of the above-mentioned semiconductor element having the switching function, within the semiconductor layer of the semiconductor element, at least the semiconductor sublayer contacting the transparent conductive layer is a p-type semiconductor layer.

Furthermore, with this kind of semiconductor device, in the semiconductor device provided with at least one or a plurality of the above-mentioned semiconductor element having the switching function, the semiconductor layer of the semiconductor element is a pin structure and is made of hydrogenated amorphous silicon films deposited successively by plasma CVD.

Now, with this kind of semiconductor device, the semiconductor element having the switching function and the photoelectric energy converting element are each provided with diode properties, and are connected in series with each other through their cathode electrodes.

Furthermore in this kind of semiconductor device, the respective lower electrodes, semiconductor layers and upper electrodes which constitute the semiconductor element having the switching function and the photoelectric energy converting element are deposited simultaneously.

Moreover, in this kind of semiconductor device, in the semiconductor device provided with one or a plurality of the photosensor element comprising the above-mentioned semiconductor element having the switching function connected in series with the above-mentioned photoelectric energy converting element, whichever one of the lower electrode and the upper electrode is located at the side opposite to the light entrance side, is at least constructed with a transparent conductive layer contacting the semiconductor layer.

There is no theoretical explanation of the operation of this kind of semiconductor device; however, the lower electrode or the upper electrode or both are made of one or not less than two conductive layers, and at least the conductive layer contacting the semiconductor layer is formed from a transparent conductive layer such as ITO, so that an interface is formed between the semiconductor layer and the transparent conductive layer. It is thought that an electrical potential barrier, or a barrier such as trap levels arising from the diffusion of material constituting the transparent conductive layer into the semiconductor layer, is formed at this interface. It is thought that consequently, even when the voltage on the semiconductor device is changed from forward bias to reverse bias, the carriers injected during forward bias are almost entirely blocked by this barrier. It is inferred that as a result, both the reverse direction current is rapidly converged and its peak value becomes small, so that the switching rate is improved.

According to another theoretical inference of the operation of this kind of semiconductor device, either or both of the lower electrode and the upper electrode are made of one or not less than two conductive layers, and at least the conductive layer in contact with the semiconductor layer is formed from a transparent conductive layer such as ITO, so that because of the transparency of this layer, light which leaks from the periphery is transmitted through the lower electrode or the upper electrode and enters the semiconductor layer. As a result of this, the number of recombination levels in the semiconductor layer is increased and the recombination rate becomes faster. It is thought that consequently, even when the voltage on the semiconductor device is changed from forward bias to reverse bias, the carriers injected during forward bias rapidly disappear through recombination. It is inferred that as a result, both the reverse direction current is rapidly converged and its peak value becomes small, so that the switching rate is improved.

Now, according to this kind of semiconductor device such as a photosensor element comprising a semiconductor element having a switching function and a photoelectric energy converting element, either or both of the lower electrode and the upper electrode which constitute the semiconductor element having the switching function are made of one or not less than two conductive layers, and at least the conductive layer contacting the semiconductor layer is formed from a transparent conductive layer such as ITO. Consequently, this semiconductor element having the switching function performs the above-inferred operation. As a result, both the reverse direction current is rapidly converged and its peak value becomes small. Thus, the signal output obtained from this photosensor element is precise and the switching rate is improved.

Moreover, according to this kind of semiconductor device such as a document reading device provided with a semiconductor element having a switching function and a photoelectric energy converting element, either or both of the lower electrode and the upper electrode which constitute the semiconductor element having the switching function are made of one or not less than two conductive layers, and at least the conductive layer contacting the semiconductor layer comprises a transparent conductive layer such as ITO. Therefore, this semiconductor element having the switching function performs the above-inferred operation. As a result of this, both the reverse direction current is rapidly converged and its peak value becomes small, so that the switching rate of the switching element is improved. As a result, the semiconductor device such as a document reading device has a reduced reverse after-image and the signal reading speed is sharply increased.

### Brief Description of the Drawings

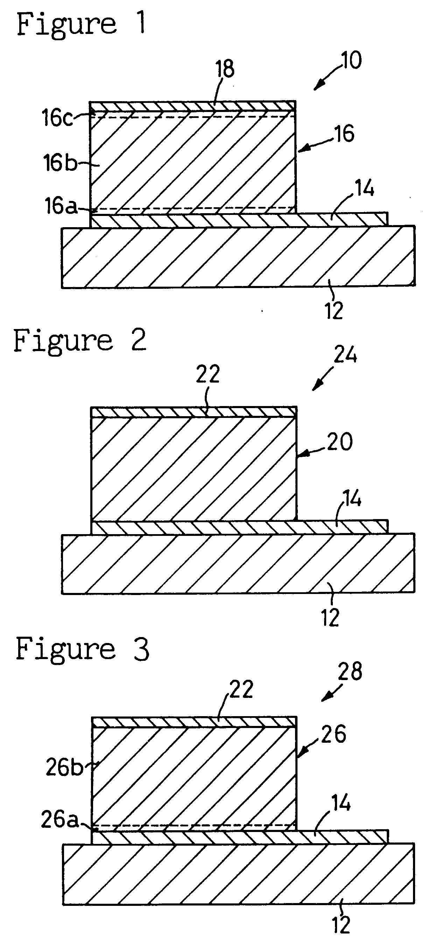

Figure 1 is a cross-sectional type drawing showing an embodiment of the switching element which is a semiconductor device of the present invention. Figures 2, 3, 4, 5, 6 and 7 are cross-sectional type drawings, each of which shows a different embodiment of the switching element which is a semiconductor device of the present invention.

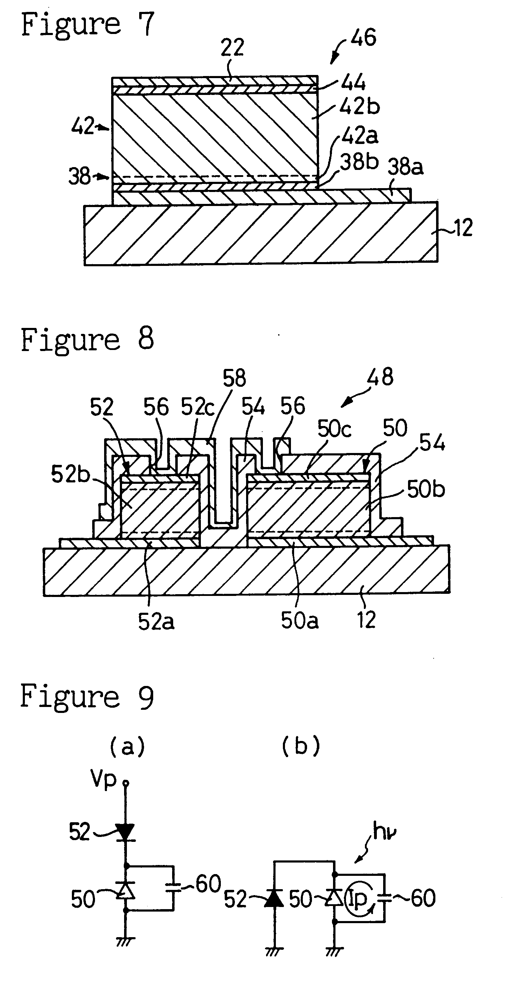

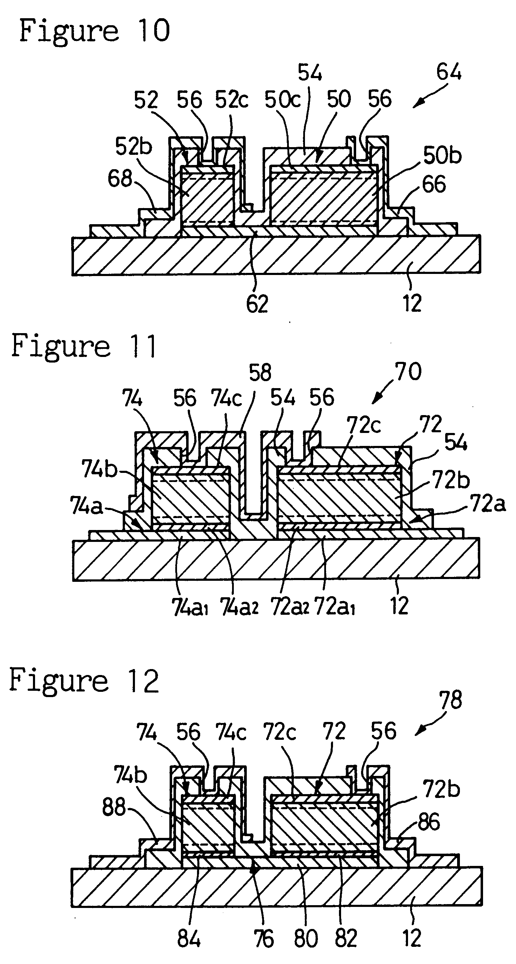

Figure 8 is a cross-sectional type drawing showing an embodiment of the photosensor element which is a semiconductor device of the present invention. Figures 9(a) and 9(b) are circuit diagrams explaining the operation of the photosensor element shown in Figure 8. Figures 10, 11 and 12 are cross-sectional type drawings each of which shows a different embodiment of the photosensor element which is a semiconductor device of the present invention.

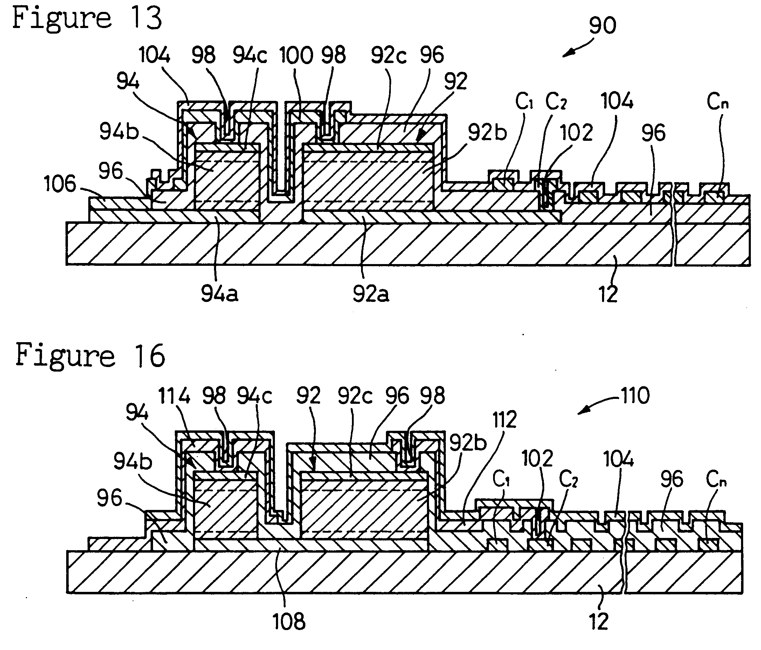

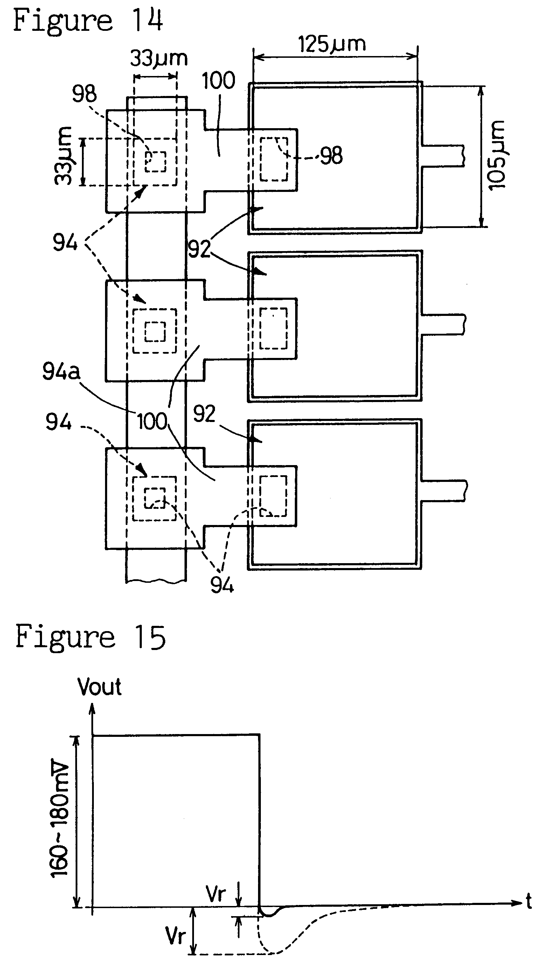

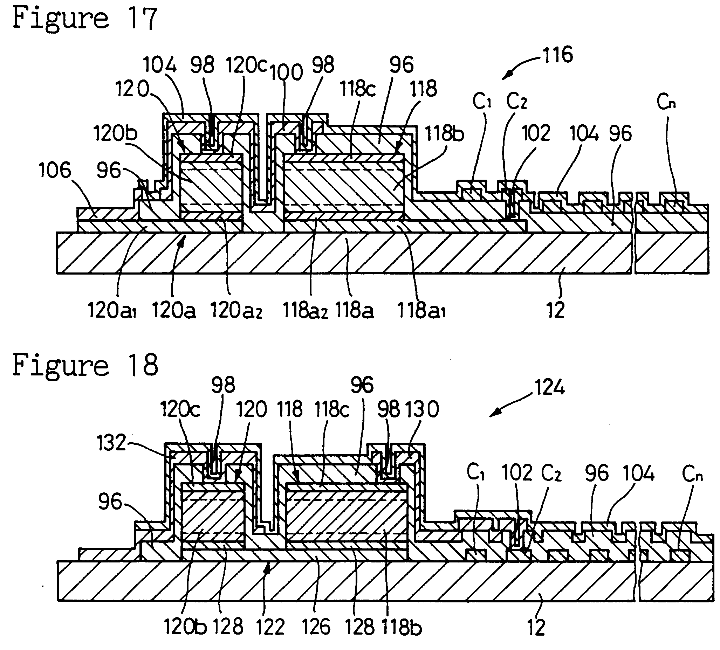

Figure 13 is a cross-sectional type drawing showing an embodiment of the document reading device which is a semiconductor device of the present invention. Figure 14 is a plan view of a portion of the document reading device shown in Figure 13. Figure 15 shows the results of a comparative experiment carried out to confirm the effect of the present invention, being a graph showing the output voltages of actually fabricated document reading devices. Figures 16, 17 and 18 are cross-sectional type drawings each of which shows a different embodiment of the document reading device which is a semiconductor device of the present invention.

Figure 19 is a cross-sectional type drawing showing an example of a prior art document reading device which is a semiconductor device. Figure 20 is a circuit diagram of the document reading device shown in Figure 19. Figure 21 is a time chart explaining the operation of the document reading device shown in Figures 19 and 20.

### Best Mode for Carrying out the Invention.

Embodiments of the semiconductor device of the present invention will now be explained in detail with reference to the drawings. First, a switching element which is a semiconductor element having a switching function, which exemplifies the semiconductor device of the present invention will be explained.

As shown in Figure 1, a switching element 10 of the present invention is constructed by fabricating, on a substrate 12 made of glass or the like, a lower transparent electrode 14 made of ITO (Indium Tin Oxide) or the like, a semiconductor layer 16 made of amorphous silicon or the like, and an upper electrode 18. Here, the semiconductor layer 16 is a pin structure comprising a p-type amorphous silicon layer 16a in which the majority carriers are holes, an i-type amorphous silicon layer 16b which is an intrinsic semiconductor, and an n-type amorphous silicon layer 16c in which the majority carriers are electrons, stacked in order from the substrate 12 side.

In the production of this switching element 10, a transparent conductive film (14) made of ITO or the like is first deposited onto the substrate 12 by a method such as electron beam or resistive heating vacuum evaporation, or DC or RF sputtering. Then a p-type amorphous silicon film (16a), an i-type amorphous silicon film (16b) and an n-type amorphous silicon film (16c) are deposited in sequence onto this, by a method such as plasma CVD. Onto this, a transparent conductive film (18) such as ITO is again deposited by a method such as vacuum evaporation or sputtering. Here, the film thickness of each of these transparent conductive films (14, 18) is preferably from about hundreds to about thousands of angstroms, but is suitably determined in consideration of the performance of the deposited amorphous silicon films, the properties of the transparent conductive films, and so forth.

Next, these films are patterned in turn, to form the lower electrode 14, the semiconductor layer 16 and the upper electrode 18. For example, in the case of patterning by photolithography, a resist solution is first applied onto the transparent conductive film (18) of the uppermost layer, and after pre-baking, exposure to light is carried out using an engraved mask having the prescribed pattern, and following this, developing and post-baking are performed. Then, in the case when ITO is used for the transparent conductive film, this transparent conductive film is etched using a mixed solution of hydrochloric acid and nitric acid, to form the upper electrode 18. Next, the amorphous silicon films (16a, 16b, 16c) are etched using a parallel plate type etching apparatus. That is to say, after evacuating the etching chamber to not more than 10⁻³ Torr, CF₄ gas and O₂ gas are introduced, and then while maintaining a pressure of 5.0 Pa, electrical power of 0.1 to 0.7 W/cm² is supplied to an electrode using a 13.56 MHz high frequency electric source. By this process, the amorphous silicon films are etched, to form the semiconductor layer 16. Then, after removing the resist used for the patterning, when the transparent conductive film (14) of the lowest layer is also patterned by a method such as photolithography, in a similar manner to the above-mentioned uppermost-layer transparent conductive film (18), to form the lower electrode 14, a switching element 10 is produced comprising the lower electrode 14, the semiconductor layer 16 and the upper electrode 18.

Here, the method for forming the lower electrode 14, the semiconductor layer 16 and the upper electrode 18 has been illustrated using the photolithography method; however, the production method is not limited in any way. For instance, by using masks or the like, the fabrication may be carried out in such a way that the films are not deposited onto unnecessary parts from the beginning.

In this switching element 10, the lower electrode 14 and the upper electrode 18 are constructed from transparent conductive layers, so that interfaces are formed at the junctions of the semiconductor layer 16 with the lower electrode 14 and the upper electrode 18 which are transparent conductive layers, and in particular with the lower electrode 14. It is thought that an electrical potential barrier, or a barrier such as trap levels arising from the diffusion of material constituting the transparent conductive layer into the semiconductor layer 16, is formed at this interface. It is thought that consequently, even when the voltage on the switching element is changed from forward bias to reverse bias, the carriers injected during forward bias are almost entirely blocked by this barrier. It is inferred that as a result of this, both the reverse direction current is converged in the order of 10⁻⁵ to 10⁻⁶ seconds and its peak value becomes small, so that the switching rate is improved. Then, when this switching element 10 is used in a document reading device, a more precise signal output can be obtained, and moreover, it is possible to increase the signal reading speed.

According to an explanation of the operation of this switching element 10 using a different inferred theory, light which leaked from the periphery is transmitted by the transparent lower electrode 14 and upper electrode 18, and enters the semiconductor layer 16. Thus, it is thought that a large number of trap levels exist in the semiconductor layer 16 made of amorphous silicon, and when light enters this semiconductor layer 16 these trap levels transform and the number of recombination levels increases. It is considered that this results in an increase in the recombination rate, so that even when the voltage on the switching element 10 is changed from forward bias to reverse bias, the carriers injected during forward bias rapidly disappear through recombination. It is inferred that by this, both the reverse direction current is converged in the order of 10⁻⁵ to 10⁻⁶ seconds and its peak value becomes small, so that the switching rate is improved.

A detailed explanation has been given above of an embodiment of the switching element of the present invention; however, the present invention is not limited to the above-mentioned embodiment, and other modes can be implemented.

For example, as shown in Figure 2, a switching element 24 may be formed by fabricating a transparent lower electrode 14 of ITO or the like, a semiconductor layer 20 made of only a layer of i-type amorphous silicon, and an opaque upper electrode 22 made of metal or the like, on a substrate 12 made of glass or the like. In this switching element 24, a Schottky barrier is formed at the interface between the i-type amorphous silicon layer (20) and the lower electrode 14, and the operation is similar to that mentioned above.

Furthermore, as shown in Figure 3, a switching element 28 may be formed by fabricating a transparent lower electrode 14 of ITO or the like, a semiconductor layer 26 made of stacked layers of p-type amorphous silicon 26a and i-type amorphous silicon 26b, and an opaque upper electrode 22 made of metal or the like, on a substrate 12 such as glass. As is apparent from this embodiment, the semiconductor layer may be a pi structure.

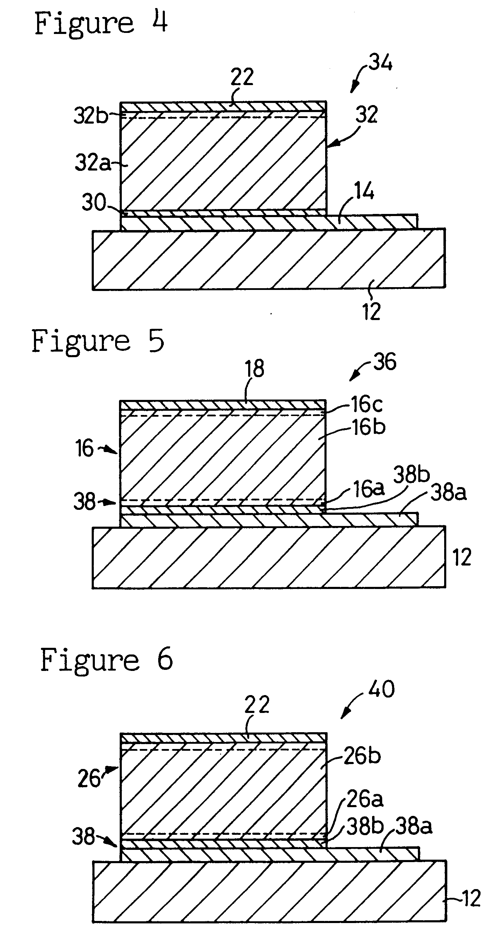

Moreover, as shown in Figure 4, a switching element 34 may be formed by fabricating a transparent lower electrode 14 of ITO or the like, an insulating layer 30, a semiconductor layer 32 made of stacked layers of i-type amorphous silicon 32a and p-type amorphous silicon 32b, and an opaque upper electrode 22 made of metal or the like, on a substrate 12 such as glass. This switching element 34 is an MIS (Metal-Insulator-Semiconductor) type, in which the semiconductor layer 32 is deposited on the lower electrode 14 with an interposed thin insulating layer 30. As is apparent from this embodiment, the semiconductor layer may be deposited directly or indirectly onto the lower electrode, and the same also applies to the other layers.

Embodiments have been explained above in which the lower electrode 14 is transparent; however, in the present invention, the transparent electrode may be either the lower electrode or the upper electrode, and moreover, both electrodes may be transparent. In other words, at least one of the lower electrode and the upper electrode should be transparent.

Now, either or both of the lower electrode and the upper electrode of the switching element which is a semiconductor device of the present invention may comprise not less than one metal layer and a transparent conductive layer deposited on this metal layer.

For example, as shown in Figure 5, a switching element 36 is formed by fabricating a lower electrode 38 having a two-layer structure, a semiconductor layer 16 made of amorphous silicon or the like, and an upper electrode 18 on a substrate 12. This lower electrode 38 having a two-layer structure comprises a metal layer 38a made of chromium Cr or the like, and a transparent conductive layer 38b, made of ITO or the like, which is deposited onto this metal layer 38a. Furthermore, the semiconductor layer 16 may be either a pin structure or an nip structure, but is preferably a pin structure consisting of a p-type amorphous silicon layer 16a in which the majority carriers are holes, an i-type amorphous silicon layer 16b which is an intrinsic semiconductor, and an n-type amorphous silicon layer 16c in which the majority carriers are electrons, stacked in order from the substrate 12 side.

In the production of this switching element 10, a metal film (38a) such as chromium Cr is first deposited on the substrate 12, by a method such as vacuum evaporation using electron beam or resistive heating, or DC or RF sputtering. Then, onto this is deposited a transparent conductive film (38b) of ITO or the like, by a method such as vacuum evaporation or sputtering. Following this, in a similar manner to the above-mentioned embodiment, a p-type amorphous silicon film, an i-type amorphous silicon film and an n-type amorphous silicon film are deposited in succession, and then onto this is deposited a conductive film. Next, the top-layer conductive film, the amorphous silicon film made of three layers and the bottom-layer transparent conductive film are patterned in the prescribed configuration in sequence, to form the upper electrode 18, the semiconductor layer 16 and a transparent conductive layer 38b which is a part of the lower electrode 38. Then, after removing the resist used for the patterning, the metal film is patterned in another prescribed configuration by again using a method such as photolithography, so that by forming the metal layer which is a part of the lower electrode 38, a switching element 36 comprising the lower electrode 38, the semiconductor layer 16 and the upper electrode 18 is produced.

Here, the amorphous silicon film is deposited after the sheet-like deposition of the metal film (38a) and the transparent conductive film (38b); however, before deposition of this amorphous silicon film, patterning of only the transparent conductive film may be carried out in advance, to form the transparent conductive layer 38b. In this case, when the metal layer 38a is formed by patterning the sheet-like metal film after fabricating the upper electrode 18 and the semiconductor layer 16, the construction becomes the same as the above-mentioned switching element 36. Furthermore, the deposition of the metal layer and transparent conductive layer may be carried out successively without breaking the vacuum, or it may be carried out non-successively by breaking the vacuum once. Moreover, the patterning method has been illustrated here using chiefly the photolithography method; however, by using masks or the like, the fabrication may be carried out in such a way that the films are not deposited onto unnecessary parts from the beginning, and the production method is not limited in any way.

In this switching element 36, the lower electrode 38 comprises a metal layer 38a and a transparent conductive layer 38b, and an interface is formed at the junction of the semiconductor layer 16 with the transparent conductive layer 38b. Therefore, this switching element 36 operates similarly to the above-mentioned switching elements. As a result of this, the reverse direction current is converged in the order of 10⁻⁵ to 10⁻⁶ seconds and its peak value becomes small, so that the switching rate is improved. Consequently, when this switching element 36 is used in a document reading device, a more accurate signal output can be obtained, and moreover, it is possible to increase the signal reading speed.

Now, as shown in Figure 6, a switching element 40 of the present invention may be formed by fabricating, on a substrate 12 such as glass, a lower electrode 38 composed of a metal layer 38a and a transparent conductive layer 38b, a semiconductor layer 26 made of stacked layers of a p-type amorphous silicon layer 26a and an i-type amorphous silicon layer 26b, and an opaque upper electrode 22 made of metal or the like. That is to say, as is apparent from this embodiment, the semiconductor layer may be a pi structure. In short, the present invention should prevent the creation of a reverse direction current in the switching element by forming an interface between the transparent conductive layer and the semiconductor layer which constitute the switching element.

Furthermore, as shown in Figure 7, a switching element 46 may be formed by fabricating, on a substrate 12 made of glass or the like, a lower electrode 38 composed of a metal layer 38a and a transparent conductive layer 38b, a semiconductor layer 42 made of stacked layers of a p-type amorphous silicon layer 42a and an i-type amorphous silicon layer 42b, an insulating layer 44, and an opaque upper electrode 22 made of metal or the like. This switching element 46 is an MIS type, in which the upper electrode 22 made of metal is deposited onto the semiconductor layer 42 with an interposed insulating layer 44. As is apparent from the present embodiment, the upper electrode may be deposited directly or indirectly onto the semiconductor layer.

Moreover, in the above-mentioned embodiments, the metal layer 38a and the transparent conductive layer 38b which constitute the lower electrode 38 have different configurations; however, they may also have an identical configuration. In addition, in the case when the present invention is applied to a switching element, various suitable kinds of construction can be employed, without explaining all about them here.

Embodiments in which the semiconductor device of the present invention is applied to a switching element have been mentioned above, but next, embodiments in which the semiconductor device of the present invention is applied to a photosensor element will be explained in detail with reference to the drawings.

As shown in Figure 8, a photosensor element 48 of the present invention is formed by fabricating, on a substrate 12 made of glass or the like, a photodiode 50 which is a photoelectric energy converting element, and a blocking diode 52 which is a switching element. The photodiode 50 and the blocking diode 52 are constructed side by side by depositing transparent lower electrodes 50a, 52a made of ITO (Indium Tin Oxide) or the like, semiconductor layers 50b, 52b having a pin structure made of amorphous silicon or the like, and transparent upper electrodes 50c, 52c made of ITO or the like, in sequence. Here, the transparency of the lower electrode 52a which constitutes the blocking diode 52 is the most important characteristic of this embodiment.

The photodiode 50 and the blocking diode 52 are covered with a transparent interlayer insulating film 54 made of SiOₓ, SiN or the like, and are connected in series and opposite polarity with each other using a coupling lead 58 through a contact hole 56 formed in this interlayer insulating film 54. That is to say, the cathode electrodes of the photodiode 50 and the blocking diode 52 are connected together.

In the production of this photosensor element 48, a transparent conductive film (50a, 52a) of ITO or the like is first deposited onto the substrate 12, using a method such as electron beam or resistive heating vacuum evaporation, or DC or RF sputtering. For example, in the case when an ITO film is deposited by DC sputtering, the substrate 12 is first set up in the deposition chamber and then the chamber is evacuated to not more than 10⁻⁵ Torr. Following this, while maintaining the substrate 12 at 100 to 250 °C, argon gas and oxygen gas are introduced in a fixed ratio, under a pressure of 0.1 to 1.0 Pa and a DC power of 0.1 to 1.0 W/cm². By this process, an ITO film can be deposited on the substrate 12. Here, the film thickness of this transparent conductive film is suitably determined in consideration of the performance of the amorphous silicon film deposited onto it, the properties of the transparent conductive film and so forth; however, for an ITO film, a thickness of about 1200 Å is preferred.

Onto this, a p-type amorphous silicon film in which the majority carriers are holes, an i-type amorphous silicon film which is an intrinsic semiconductor, and an n-type amorphous silicon film in which the majority carriers are electrons are deposited successively, using a method such as plasma CVD.

Then, onto this, a transparent conductive film made of ITO or the like is again deposited by a method such as sputtering or vacuum evaporation, similarly to the above-mentioned lowest-layer transparent conductive film. Here, since the film thickness of this transparent conductive film is also suitably determined in consideration of the performance of the amorphous silicon film, the properties of the transparent conductive film and so forth, a thickness of about hundreds to about thousands of angstroms is preferred; however, for an ITO film, the thickness is preferably about 600 Å.

Next, by patterning these films in order, the lower electrodes 50a, 52a, the semiconductor layers 50b, 52b, and the upper electrodes 50c, 52c are formed. For example, in the case when photolithography is used for the patterning, a resist solution is first applied onto the uppermost-layer transparent conductive film, and after pre-baking, exposure to light is performed using a mask engraved with the prescribed pattern, and then development and post-baking are carried out. Then, in the case when ITO is used for the transparent conductive film, this transparent conductive film is etched using a mixed solution of hydrochloric acid and nitric acid, to form the upper electrodes 50c, 52c. Next, the amorphous silicon films are etched using a parallel plate type etching apparatus. That is to say, after evacuating the etching chamber to not more than 10⁻³ Torr, CF₄ gas and O₂ gas are introduced, and then while maintaining a pressure of 5.0 Pa electric power of 0.1 to 0.7 W/cm² is supplied to an electrode using a 13.56 MHz high frequency electric source. By this process, the amorphous silicon films are etched, to form the semiconductor layers 50b, 52b. Moreover, after removing the resist used for the patterning, the lowest-layer transparent conductive film is also patterned by a method such as photolithography, in a similar manner to the above-mentioned uppermost-layer transparent conductive film, and by fabricating the lower electrodes 50a, 52a, the photodiode 50 and the blocking diode 52 can be formed.

Next, SiOₓ, SiNₓ or the like is deposited onto the photodiode 50 and the blocking diode 52, by using a method such as thermal CVD, normal pressure CVD, plasma CVD or sputtering, and is then patterned in the prescribed configuration by a method such as photolithography, to form an interlayer insulating film 54. For example, in the case when a silicon oxide film is deposited by plasma CVD, the deposition chamber is evacuated to not more than 10⁻² Torr, and after heating up and maintaining the substrate 12 at the prescribed temperature, 20 to 60 sccm of silane gas and 150 to 300 sccm of nitrous oxide gas are introduced, and the pressure is maintained at 0.3 to 1.2 Torr. Here, hydrogen gas or nitrogen gas may be introduced as occasion demands. After allowing the pressure to stabilize, an electric power of 0.01 to 0.5 W/cm² is supplied to the electrode on the opposite face to the substrate 12 using a 13.56 MHz high frequency electric source. Here, the electric power to be supplied depends on the structure of the apparatus and the film quality to be deposited, and furthermore, in the case of a silicon oxide film, a parallel plate type etching apparatus can be used. Thus, the silicon oxide film is patterned, to form the interlayer insulating film 54. Here, contact holes 56 should be formed on the photodiode 50 and the blocking diode 52 at this time.

Onto these is further deposited a single layer or a multilayer of metal such as Cr, Ni, Pd, Ti, Mo, Ta or Al, more preferably a double layer of 500 Å thick Cr and 1.5 µm thick Al, using a method such as vacuum evaporation or sputtering. Then, a coupling lead 58 is formed by patterning this layer in the prescribed configuration using a method such as photolithography. By this, the upper electrodes 50c, 52c are electrically connected together using the coupling lead 58, to produce a photosensor element 48 comprising the photodiode 50 and the blocking diode 52. Here, in the case when the coupling lead 58 is a double layer of Al and Cr, the etching of the Al should be carried out using a mixed solution of phosphoric acid, nitric acid and acetic acid, and on the other hand, the etching of the Cr should be carried out using ceric ammonium nitrate. Furthermore, these materials need not necessarily be metals, and any material which can make an electrical connection can be used without any particular limitation.

Here, the patterning method has been illustrated using chiefly the photolithography method, but the production method is not limited in any way. For instance, by using masks or the like, the fabrication may he carried out in such a way that the films are not deposited onto unnecessary parts from the beginning.

The operation of this photosensor element 48 will now be explained.

As shown in Figure 9(a), the anode electrode of the blocking diode 52 (lower electrode 52a) opposes the anode electrode of the photodiode 50 (lower electrode 50a), and when a positive potential Vp is applied, the blocking diode 52 becomes forward biased and the photodiode 50 becomes reverse biased. This causes the parallel capacitance 60 of the photodiode 50 to charge up, so that the electrical potential at the junction between the photodiode 50 and the blocking diode 52 becomes high. Then, as shown in Figure 9(b), when the anode electrode of the blocking diode 52 is earthed, the blocking diode 52 becomes reverse biased. Under this condition, when light enters the photodiode 50, the parallel capacitance of the photodiode 50 is discharged through the generated photocurrent Ip. Following this, when a positive potential Vp is again applied to the anode electrode of the blocking diode 52, the blocking diode 52 becomes forward biased and the parallel capacitance 60 of the photodiode 50 is charged up again. The charging current flowing at this time is equal to the photocurrent Ip, and flows as an output current. Therefore, by detecting this output current, the amount of light which entered the photodiode 50 is detected.

In the present embodiment, since the lower electrode 52a and the upper electrode 52c of the blocking diode 52 are formed of transparent conductive layers, interfaces are formed at the junctions between the semiconductor layer 52b and both the lower electrode 52a and the upper electrode 52c which are transparent conductive layers. Therefore, it is considered that the blocking diode 52 which is a switching element operates similarly as mentioned above. As a result of this, both the reverse direction current is converged in the order of 10⁻⁵ to 10⁻⁶ seconds and its peak value becomes small. Consequently, an accurate signal output is obtained from the photosensor element 48 and its switching rate is improved. Moreover, when this photosensor element 48 is used in a document reading device, a more precise signal output can be obtained, and furthermore it is also possible to increase the signal reading speed.

A detailed explanation of an embodiment of the photosensor element of the present invention has been given above; however, the present invention applying to the photosensor element is not limited to the above-mentioned embodiment, and various other modes can be implemented.

For example, in the above-mentioned embodiment, the upper electrode 50c which constitutes the photodiode 50 and the upper electrode 52c which constitutes the blocking diode 52 are interconnected using a coupling lead 58; however, as shown in Figure 10, a photosensor element 64 may be constructed in which the lower electrode 62 which constitutes the photodiode 50 and the lower electrode 62 which constitutes the blocking diode 52 are common, so that the photodiode 50 and the blocking diode 52 are connected in series by this lower electrode 62. In this case, it is sufficient that the lower electrode 62 is formed of a transparent conductive layer made of ITO or the like. Furthermore, it is sufficient that the upper electrode 50c of the photodiode 50 and the upper electrode 52c of the blocking diode 52 are led out to the exterior by a respective lead-out conductor 66, 68. In this embodiment, the photodiode 50 and the blocking diode 52 are interconnected in series and opposite polarity with each other by connecting their anode electrodes together.

Here, in the above-mentioned embodiments, since for reasons such as the simplification of the manufacturing process, the respective lower electrodes 50a, 52a, semiconductor layers 50b, 52b and upper electrodes 50c, 52c which constitute the photodiode 50 and the blocking diode 52 are simultaneously deposited, they are composed of the same respective materials; however, the upper electrode 50c which constitutes the photodiode 50 must be transparent, but the upper electrode 52c which constitutes the blocking diode 52 need not be transparent. Furthermore, the lower electrode 50a which constitutes the photodiode 50 need not be transparent, but at least the lower electrode 52a which constitutes the blocking diode (switching element) 52 should be transparent.

Embodiments of the photosensor element which is a semiconductor device of the present invention have been explained above, in which at least the lower electrode of the switching element is made to be transparent; however, in the photosensor element, at least either the lower electrode or the upper electrode of the switching element, or both, may be composed of not less than one layer of a metal layer and a transparent conductive layer which is deposited onto this metal layer. This embodiment will now be explained in detail with reference to the drawings.

As shown in Figure 11, the photosensor element 70 of the present embodiment is formed, similarly to the embodiments outlined above, by fabricating a photodiode 72 which is a photoelectric energy converting element and a blocking diode 74 which is a switching element on a substrate 12 made of glass or the like.

The photodiode 72 and the blocking diode 74 are formed side by side by the sequential deposition of lower electrodes 72a, 74a having a two-layer structure, semiconductor layers 72b, 74b having a pin structure made of amorphous silicon or the like, and transparent upper electrodes 72c, 74c made of ITO (Indium Tin Oxide) or the like. The lower electrode 74a of the blocking diode 74 comprises a metal layer 74a₁ made of chromium Cr or the like, and a transparent conductive layer 74a₂ made of ITO or the like, which is deposited onto this metal layer 74a₁. This point is the most important characteristic of the present embodiment, while the other characteristics are similar to the above-mentioned embodiments, in that the photodiode 72 and the blocking diode 74 are covered with a transparent interlayer insulating film 54 of SiOₓ, SiNₓ or the like, and are connected in series and opposite polarity with each other using a coupling lead 58 through contact holes 56 formed in this interlayer insulating film 54
In the production of this photosensor element 70, a metal film such as chromium Cr is first deposited onto the substrate 12 by a method such as electron beam or resistive heating vacuum evaporation, or DC or RF sputtering. Then, a transparent conductive film made of ITO or the like is deposited onto this by a method such as vacuum evaporation or sputtering. For example, in the case when the metal film and the transparent conductive film are deposited by DC sputtering, the substrate 12 is first set up in the deposition chamber, and after evacuating the chamber to not more than 10⁻ ⁵ Torr, argon gas and oxygen gas are introduced in a set ratio, while maintaining the substrate 12 at 100 to 250 °C, and a metal film and a transparent conductive film are deposited in sequence under a pressure of 0.1 to 1.0 Pa and DC power of 0.1 to 1.0 W/cm².

After this, in a similar manner to the above-mentioned embodiments, a p-type, an i-type and an n-type amorphous silicon film are deposited in order, and then a transparent conductive film of ITO or the like is deposited. Here, the film thicknesses of the metal film and the transparent conductive films are each preferably about hundreds to about thousands of angstroms, but are suitably determined in consideration of the properties of these films, the performance of the amorphous silicon film, and so forth. For example, in the case when chromium Cr, is used for the metal film and ITO is used for the transparent conductive film, the film thickness of the metal film is preferably from about 150 to about 2000 Å, the film thickness of the bottom-layer transparent conductive film (72a₂, 74a₂) is preferably about 1200 Å, and the film thickness of the top-layer transparent conductive film (72c, 74c) is preferably about 600 Å.

Then, in a similar manner to the above-mentioned embodiments, the top-layer transparent conductive film, the amorphous silicon film made of 3 layers, and the bottom-layer transparent conductive film are patterned in order in the prescribed configuration to form the upper electrodes 72c, 74c, the semiconductor layers 72b, 74b, and the transparent conductive layers 72a₂, 74a₂ which are parts of the lower electrodes 72a, 74a. Following this, after removing the resist used for the patterning, the metal film is patterned in a different prescribed configuration, again using a method such as photolithography, to form the metal layers 72a₁, 74a₁ which are parts of the lower electrodes 72a, 74a. By this, the photodiode 72 and the blocking diode 74 are formed. Here, in the case when chromium Cr is used for the metal film, the etching should be performed using ceric ammonium nitrate or the like.

Next, in a similar manner to the above-mentioned embodiments, an interlayer insulating film 54 and contact holes 56 are fabricated on the photodiode 72 and the blocking diode 74, and after further depositing a single layer or a multilayer of metal onto this, patterning is carried out and a coupling lead 58 is formed. By this, the upper electrodes 72c, 74c are electrically connected together by the coupling lead 58, to produce a photosensor element 70 comprising the photodiode 72 and the blocking diode 74.

Here, the amorphous silicon film is deposited after the sheet-like deposition of the metal film and the transparent conductive film; however, before depositing this amorphous silicon film, the transparent conductive film only may be patterned in advance to form the transparent conductive layers 72a₂, 74a₂. In this case, when the sheet-like metal film is patterned to form the metal layers 72a₁, 74a₁ after fabricating the upper electrodes 72c, 74c and the semiconductor layers 72b, 74b, a similar construction to the above-mentioned photosensor element 70 is obtained. Furthermore, the metal layer and the transparent conductive layer may be deposited successively without breaking the vacuum, or non-successively by breaking the vacuum once. Moreover, here, the patterning method has been illustrated by using mainly the photolithography method; however, by using masks or the like, the fabrication may be carried out in such a way that the films are not deposited onto unnecessary parts from the beginning, and the production method is not limited in any way.

Since the operation of this photosensor element 70 is similar to the operation of the photosensor element 48 explained earlier, an explanation is omitted here.

Now, for example, in the above-mentioned embodiment, the upper electrode 72c which constitutes the photodiode 72 and the upper electrode 74c which constitutes the blocking diode 74 are connected using a coupling lead 58; however, as shown in Figure 12, the lower electrode 76 which constitutes the photodiode 72 and the lower electrode 76 which constitutes the blocking diode 74 may be common, so that the photodiode 72 and the blocking diode 74 are connected by this lower electrode 76, to form a photosensor element 78. In this case, the metal layer 80 and the transparent conductive layers 82, 84 should be deposited in sequence, to form the lower electrode 76, so that an interface is formed at the junction between the semiconductor layer 74b and the transparent conductive layer 84. Furthermore, the upper electrode 72c of the photodiode 72 and the upper electrode 74c of the blocking diode 74 should be each led out to the exterior by respective lead-out conductors 86, 88 through contact holes 56. In this embodiment, the photodiode 72 and the blocking diode 74 are connected in series and opposite polarity with each other by connecting their anode electrodes together.

In the above-mentioned embodiments, the metal layers 72a₁, 74a₁, 80 and the transparent conductive layers 72a₂, 74a₂, 82, 84 have different configurations; however, they may also have identical configurations.

Furthermore, in the above-mentioned embodiments, since for reasons such as the simplification of the production process, the respective lower electrodes 72a, 74a, semiconductor layers 72b, 74b and upper electrodes 72c, 74c which constitute the photodiode 72 and the blocking diode 74 are deposited simultaneously, they are composed of the same respective materials. Nevertheless, the upper electrode 72c which constitutes the photodiode 72 must be transparent, but the upper electrode 74c which constitutes the blocking diode 74 need not be transparent. Furthermore, the lower electrode 72a which constitutes the photodiode 72 need not be composed of a metal layer and a transparent conductive layer, but at least the lower electrode 74a which constitutes the blocking diode (switching element) 74 should be constructed of a metal layer 74a₁ and a transparent conductive layer 74a₂. In short, the present invention should prevent the generation of a reverse direction current in the switching element by forming an interface between the semiconductor layer and the transparent conductive layer which constitute the switching element.

Embodiments in which the semiconductor device of the present invention is applied to a switching element and a photosensor element have been explained above, but the present invention may be further applied to a document reading device. Embodiments in which the present invention is applied to a document reading device will be now explained in detail with reference to the drawings.

As shown in Figures 13 and 14, a document reading device 90 related to the present invention is constructed by fabricating, on a substrate 12 made of glass or the like, photodiodes 92 which are photoelectric energy converting elements, blocking diodes 94 which are switching elements, and channel leads C₁, C₂,..., Cₙ used to read out the electrical signals from the photodiodes 92. Here, the photosensor element comprises the photodiode 92 and the blocking diode 94.

The photodiode 92 and the blocking diode 94 are formed side by side by the sequential deposition of lower transparent electrodes 92a, 94a made of ITO (Indium Tin Oxide), SnO₂ or the like, semiconductor layers 92b, 94b having a pin structure made of amorphous silicon a-Si or the like, and transparent upper electrodes 92c, 94c made of ITO, SnO₂ or the like.

The photodiode 92 and the blocking diode 94 are covered with a transparent interlayer insulating film 96 made of SiOₓ, SiNₓ or the like, and are connected in series and opposite polarity with each other by a coupling lead 100 through contact holes 98 formed in this interlayer insulating film 96. That is to say, the photodiode 92 and the blocking diode 94 are connected together by their cathode electrodes. On the other hand, the lower electrode 92a of the photodiode 92 is connected to the respective channel lead C₁, C₂,..., Cₙ through a contact hole 102 formed in the interlayer insulating film 96. Furthermore, this entire structure is covered with a protective film 104.

Similarly to the prior art, the photodiodes 92 and blocking diodes 94 are divided every n diode pairs into m blocks B₁, B₂,..., Bₘ, to form a one-dimensional array of m by n diode pairs, in which the anode electrodes of the blocking diodes 94 are connected commonly within each of the blocks B₁, B₂,..., Bₘ, and the anode electrodes of the photodiodes 92 in the same relative positions in the individual blocks B₁, B₂,..., Bₘ are connected together commonly using the respective channel leads C₁, C₂,..., Cₙ.

Here, in the production method of this document reading device 90, in a similar manner to the production method of the above-mentioned photosensor element, after first depositing a transparent conductive film such as ITO or SnO₂ onto the substrate 12, amorphous silicon films in the order of p-type, i-type and n-type are deposited successively onto this, and further, onto this is deposited a transparent conductive film such as ITO or SnO₂. The film thickness of this uppermost-layer transparent conductive film is preferably from about hundreds to about thousands of angstroms, but is suitably determined in consideration of the performance of the amorphous silicon film, the properties of the transparent conductive film and so-forth.

Then, by patterning the uppermost-layer transparent conductive film and the amorphous silicon film made of 3 layers using a method such as photolithography, followed by patterning of the lowest-layer transparent conductive film also using a method such as photolithography, the photodiode 92 and the blocking diode 94 are formed.

Next, SiOₓ, SiNₓ or the like is deposited onto the photodiode 92 and the blocking diode 94, and is then patterned in the prescribed configuration using a method such as photolithography, to form an interlayer insulating film 96. That is to say, contact holes 98 are formed on the photodiode 92 and the blocking diode 94 and a contact hole 102 is formed on the lower electrode 92a, and the interlayer insulating film 96 is removed from the region where the lead-out electrode 106 will be fabricated on the lower electrode 94a.

Onto this is further deposited a metal single layer or multilayer of Cr, Ni, Pd, Ti, Mo, Ta, Al or the like, using a method such as vacuum evaporation or sputtering, and by patterning this in the prescribed configuration using a method such as photolithography, the coupling lead 100, the channel leads C₁, C₂,..., Cₙ and the lead-out electrode 106 are formed. By this, the upper electrodes 92c, 94c and the coupling lead 100 are electrically connected through the contact holes 98, and the lower electrode 92a and the respective channel lead C₁, C₂,..., Cₙ are electrically connected through the contact hole 102. Here, these materials need not necessarily be metals, and any material which can make an electrical connection can be used without any particular limitation.

Finally, silicon oxide, silicon nitride, tantalum oxide or the like is deposited over the entire structure using a method such as plasma CVD, sputtering or the like, and by patterning this in the prescribed pattern using a method such as photolithography, a protective film 104 covering all regions other than the lead-out electrode 106 and the lead-out electrodes of the channel leads C₁, C₂,..., Cₙ (not shown in the drawing) is fabricated. This protective film 104 is to protect the photodiode 92, the blocking diode 94, the channel leads C₁, C₂,..., Cₙ, and so forth, from moisture or cuts.

In this document reading device 90, since the lower electrode 94a of the blocking diode 94 which is a switching element is formed of a transparent conductive layer, an interface is formed at the junction between the semiconductor layer 94b and the lower electrode 94a. It is thought that an electrical potential barrier, or a barrier such as trap levels arising from the diffusion of material of the lower electrode 94a comprising a transparent conductive layer into the semiconductor layer 94b, is formed at this interface. It is thought that as a result, the reverse direction current Ir₁, Ir₂,..., Irₙ flowing immediately after switching a block B₁, B₂,..., Bₘ from the read-out state to the storage state is almost completely blocked by this barrier, so that both the reverse direction current Ir₁, Ir₂,..., Irₙ is converged in the order of 10⁻⁵ to 10⁻⁶ seconds and its peak value becomes small. As a result of this, the switching rate of the blocking diode 120 is improved and the reverse after-image is sharply reduced. Consequently, a precise signal output is naturally obtained and it is also possible to increase the reading speed. Moreover, since the reverse after-image is reduced enough, a precise signal output can be ensured even in the case when reading a document under low intensity illumination, so that reduction of the electric power consumption can be promoted. Here, similarly as mentioned above, it is thought that one of the reasons is that an increase in the number of recombination levels causes a faster recombination rate due to the light leaked from the periphery entering the semiconductor layer 94b of the blocking diode 94, since the lower electrode 94a of the blocking diode 94 which is a switching element is composed of a transparent conductive layer.

In order to confirm this kind of effect, an example of the document reading device of the present invention and a comparative example of a prior art document reading device were fabricated, and a comparative experiment was carried out, as explained below.

### Example 1

A document reading device of the present invention was first fabricated using the method indicated as follows.

Using a substrate 12 of alkali-free glass (#7059) manufactured by Corning, a 1200 Å thick ITO film was first deposited onto this substrate 12 by DC sputtering. That is to say, the substrate was set up in the deposition chamber, and after evacuating the chamber to not more than 10⁻⁵ Torr, the substrate 12 was maintained at 100 to 250 °C and by introducing argon gas and oxygen gas in a set ratio, under a pressure of 0.1 to 1.0 Pa and DC power of 0.1 to 1.0 W/cm², a film of ITO was deposited onto the substrate 12. Onto this was further deposited in sequence, a 50 to 300 Å thick p-type amorphous silicon film, a 7000 to 12000 Å thick i-type amorphous silicon film and a 50 to 300 Å thick n-type amorphous silicon film, using plasma CVD. Then, onto this again was deposited a 600 Å thick ITO film by a similar method to the above-mentioned ITO film.

Then the uppermost-layer ITO film and the amorphous silicon film made of 3 layers were patterned using photolithography, to form the upper electrodes 92c, 94c and the semiconductor layers 92b, 94b. That is to say, a resist solution was applied onto the uppermost-layer ITO film, and, after performing a pre-bake, exposure to light was carried out using an engraved mask with the prescribed pattern, and then developing and post-baking were further performed. Then, after etching the ITO film using a mixed solution of hydrochloric acid and nitric acid, the amorphous silicon film was etched using a parallel plate type etching apparatus. Here, after evacuating the chamber to not more than 10⁻³ Torr, CF₄ gas and O₂ gas were introduced, and while maintaining a pressure of 5.0 Pa, electric power of 0.1 to 0.7 W/cm² was supplied to an electrode using a high frequency electric source of 13.56 MHz, and the amorphous silicon film was etched. Then, after removing the resist used for the patterning, the lowest-layer ITO film was patterned also using photolithography, in a similar manner to the above-mentioned uppermost-layer ITO film, to form the lower electrodes 92a, 94a.

Here, the number of photodiodes 92 and blocking diodes 94 were each 1728, and these were divided every 32 diode pairs into 56 blocks of diode pairs. Furthermore, as shown in Figure 14, the size of the photodiode 92 was 105 µm by 125 µm, and the size of the blocking diode 94 was 33 µm by 33 µm.

Next, a 1.5 µm thick silicon oxide film was deposited onto these photodiodes 92 and blocking diodes 94 by plasma CVD. That is to say, after evacuating the chamber to not more than 10⁻² Torr, the substrate 12 was heated up and maintained at the prescribed temperature, 20 to 60 sccm of silane gas and 150 to 300 sccm of nitrous oxide gas were introduced, and the pressure was maintained at 0.3 to 1.2 Torr (here, nitrogen gas is introduced as occasion demands). Then, after allowing the pressure to stabilize, electric power of 0.01 to 0.5 W/cm² was supplied to the electrode on the opposite face to the substrate 12 using a high frequency electrical source of 13.56 MHz, and a silicon oxide film was deposited. The interlayer insulating film 96 was then formed by patterning in the prescribed configuration using photolithography. A parallel plate type etching apparatus was used for this etching.

Onto this was further deposited a double layer of Cr and Al by sputtering, followed by patterning in the prescribed configuration using photolithography, to form the coupling leads 100, the channel leads C₁, C₂,..., Cₙ and the lead-out electrodes 106. Here, the film thickness of the Cr was 500 Å and the film thickness of the Al was 1.5 µm. Furthermore, the etching of the Al was carried out using a mixed solution of phosphoric acid, hydrochloric acid, nitric acid and acetic acid, and the etching of the Cr was carried out using ceric ammonium nitrate.

Finally, a 5000 Å thick silicon nitride film was deposited over the entire structure by plasma CVD. That is to say, after evacuating the chamber to not more than 10⁻² Torr, the substrate 12 was heated up and maintained at the prescribed temperature, 20 to 60 sccm of silane gas and 150 to 300 sccm of ammonia gas were introduced, and a pressure of 0.3 to 1.2 Torr was maintained (here, hydrogen gas or nitrogen gas are introduced as occasion demands). Then, after allowing the pressure to stabilize, electric power of 0.01 to 0.5 W/cm² was supplied to the electrode on the opposite face to the substrate 12 using a high frequency electric source of 13.56 MHz, and a silicon nitride film was deposited. Patterning was then performed in the prescribed configuration using photolithography, to form the protective film 104. In this etching, a parallel plate type etching apparatus was also used.

### Comparative Example 1

As a comparative example of a prior art document reading device, a device was fabricated in which only the material of the lower electrodes 92a, 94a was different from the above-mentioned Example 1. That is to say, instead of the above-mentioned ITO film, a 1500 to 2000 Å thick chromium film was deposited by sputtering, and by patterning this using photolithography, opaque lower electrodes 92a, 94a were formed.

Next, drive circuits and processing circuits were connected to Example 1 and Comparative Example 1, and at a clock pulse frequency of 500 kHz and a reading speed of 5 milliseconds/line, a document varying between white and black was read under an illumination intensity of 20 Lux. As a result, an output voltage Vout was obtained from the signal processing circuit, as shown in Figure 15. In this drawing, the solid line shows the output voltage Vout of the example, and the dashed line shows the output voltage Vout of the comparative example.

Thus, immediately after reading white, a reverse after-image Vr appears in the output voltage Vout. This causes black which is read immediately after reading white to become blacker than the normal black. However, the reverse after-image Vr of Example 1 became smaller than the reverse after-image of Comparative Example 1, so that its converging time was also shortened. These results are shown collectively in Table 1. Here, the output voltage Vout corresponding to white was 160 to 180 mV.

**Table 1**

| | Reverse after-image Vr (mV) |
|---|---|
| Example 1 | 3 - 5 |
| Example 2 | 3 - 6 |
| Comparative Example 1 | 20 - 30 |

An embodiment of the document reading device of the present invention has been explained in detail above; however, the present invention is not limited to the above-mentioned embodiment, and other modes can be implemented.

For example, in the above-mentioned embodiment, the upper electrode 92c which constitutes the photodiode 92 and the upper electrode 94c which constitutes the blocking diode 94 are connected using a coupling lead 100; however, as shown in Figure 16, the lower electrode 108 which constitutes the photodiode 92 and the lower electrode 108 which constitutes the blocking diode 94 may be common, and by using this lower electrode 108 the photodiode 92 and the blocking diode 94 may be connected and a document reading device 110 formed. In this case, the lower electrode 108 is made of ITO or the like. Furthermore, the upper electrode 92c of the photodiode 92 is led out using a lead-out conductor 112 through a contact hole 98 formed in the interlayer insulating film 96, and is connected to a channel lead C₁, C₂,..., Cₙ through a contact hole 102. Moreover, the upper electrode 94c of the blocking diode 94 is constructed to be led out to the exterior using a lead-out conductor 114 through a contact hole 98. In this embodiment, the photodiode 92 and the blocking diode 94 are connected in series and opposite polarity with each other by connecting their anode electrodes together.

Furthermore, in the above-mentioned embodiments, the anode electrodes or cathode electrodes of the blocking diodes 94 are connected commonly within each block B₁, B₂..., Bₘ, and the anode electrodes or cathode electrodes of the photodiodes 92 in the same relative positions in the individual blocks B₁, B₂,..., Bₘ are connected together using the respective channel leads C₁, C₂,..., Cₙ. However, the photodiode and blocking diode placements may be reversed, so that the anode electrodes or cathode electrodes of the photodiodes are connected commonly within each block, and the anode electrodes or cathode electrodes of the blocking diodes in the same relative positions in the individual blocks are connected together using the respective channel leads. That is to say, the photosensor elements comprising the photodiode (photoelectric energy converting element) and the blocking diode (switching element), are divided every set number of elements into a plurality of blocks in a one-dimensional multiple array, in which the photosensor elements should be connected commonly on any one side within each block, and those in the same relative positions in the individual blocks should be connected together commonly on the other side using the channel leads.

Furthermore, in the above-mentioned embodiments, since for reasons such as the simplification of the production steps, the respective lower electrodes 92a, 94a, semiconductor layers 92b, 94b and upper electrodes 92c, 94c which constitute the photodiode 92 and the blocking diode 94 are deposited simultaneously, they are composed of the same respective materials; however, the upper electrode 92c which constitutes the photodiode 92 must be transparent, but the upper electrode 94c which constitutes the blocking diode 94 need not be transparent. Furthermore, the lower electrode 92a which constitutes the photodiode 92 need not be transparent, but at least the lower electrode 94a which constitutes the blocking diode (switching element) 94 should be transparent.

Embodiments of the document reading device which is a semiconductor device of the present invention have been explained above, in which the lower electrode of the blocking diode 94 which is a switching element constituting the document reading device is constructed using at least a transparent conductive layer. However, in the document reading device of the present invention, at least the lower electrode which constitutes the switching element may be constructed of not less than one layer of a metal layer and a transparent conductive layer which is deposited onto this metal layer. An embodiment of a document reading device constructed in this way will now be explained in detail, with reference to the drawings.

As shown in Figure 17 and in the above-mentioned Figure 14, a document reading device 116 of the present invention is formed by fabricating, on a substrate 12 made of glass or the like, photodiodes 118 which are photoelectric energy converting elements, blocking diodes 120 which are switching elements, and channel leads C₁, C₂,..., Cₙ for reading out the electrical signals from the photodiodes 118. Here, a photosensor element is constructed from the photodiode 118 and the blocking diode 120.

The photodiode 118 and the blocking diode 120 are formed side by side by depositing in order, lower electrodes 118a, 120a having a two-layer structure, semiconductor layers 118b, 120b having a pin structure made of amorphous silicon or the like, and transparent upper electrodes 118c, 120c made of ITO (Indium Tin Oxide) or the like. These lower electrodes 118a, 120a comprise a metal layer 118a₁, 120a₁ made of Cr, Ni, Pd, Ti, Mo, Ta, Al or the like, and a transparent conductive layer 118a₂, 120a₂ made of ITO, SnO₂, TiO₂ or the like.

Furthermore, the photodiode 118 and the blocking diode 120 are, similarly to the above-mentioned embodiments, covered with a transparent interlayer insulating film 96, and are connected in series and opposite polarity with each other using a coupling lead 100 through contact holes 98 formed in this interlayer insulating film 96. On the other hand, the lower electrode 118a of the photodiode 118 is connected to the respective channel lead C₁, C₂,..., Cₙ through a contact hole 102 formed in the interlayer insulating film 96, and moreover, the entire structure is covered with a protective film 104. Furthermore, the other constructions are carried out similarly to the above-mentioned embodiments.

Here, an example of the production method of this document reading device 116 having different aspects from the above-mentioned will be mainly simply explained.

A metal film of Cr, Ni, Pd, Ti, Mo, Ta, Al or the like, is first deposited onto a substrate 12 by a method such as electron beam or resistive heating vacuum evaporation, or DC or RF sputtering. Then onto this is deposited a transparent conductive film of ITO, SnO₂ or the like by a method such as vacuum evaporation or sputtering. Onto this is further deposited, sequentially, a p-type, an i-type and an n-type amorphous silicon film, and onto this is further deposited a transparent conductive film. Here, the film thicknesses of the metal film and the transparent conductive films are preferably from about hundreds to about thousands of angstroms, but are suitably determined in consideration of the properties of these films, the performance of the amorphous silicon film, and so forth. Next, using a method such as photolithography, the top-layer transparent conductive film, the amorphous silicon film made of 3 layers, and the bottom-layer transparent conductive film are patterned in the prescribed configuration, and then the metal film is patterned in a different prescribed configuration, to form the photodiode 118 and the blocking diode 120.

Then after depositing SiOₓ, SiNₓ or the like onto the photodiode 118 and the blocking diode 120 by normal methods, the interlayer insulating film 96 is formed by patterning this in the prescribed configuration. At this time, the contact holes 98, 102 are formed on the photodiode 118, the blocking diode 120 and the metal layer 118a₁ at the prescribed positions, and the interlayer insulating film 96 is removed from the region where the lead-out electrode 106 will be formed on the metal layer 120a₁.

After depositing a metal single layer or multilayer onto this by normal methods, the coupling lead 100, the channel leads C₁, C₂,..., Cₙ, and the lead-out electrode 106 are formed by patterning this in the prescribed configuration. By this, the upper electrodes 118c, 120c are electrically connected together by the coupling lead 100, and the metal layer 118a₁ and the respective channel lead C₁, C₂,..., Cₙ are electrically connected. Here, these materials need not necessarily be metals, and any material which can make an electrical connection can be used without any particular limitation. Finally, silicon oxide, silicon nitride, tantalum oxide or the like is deposited over the entire structure, and is then patterned in the prescribed configuration, to give a protective film 104 covering the entire region other than the lead-out electrodes 100 and the lead-out electrodes of the channel leads C₁, C₂,..., Cₙ (not shown in the drawing).

Here, the amorphous silicon film is deposited after the sheet-like deposition of the metal film and the transparent conductive film; however, before depositing this amorphous silicon film, the transparent conductive film only may be patterned in advance, to form the transparent conductive layers 118a₂, 120a₂. In this case, after fabricating the upper electrodes 118c, 120c and the semiconductor layers 118b, 120b, the metal layers 118a₁, 120a₁ are formed by patterning the sheet-like metal film, to form a construction similar to the above-mentioned document reading device 116. Furthermore, the deposition of the metal layer and the transparent conductive layer may be carried out successively without breaking the vacuum, or it may be carried out non-successively by breaking the vacuum once. Moreover, the patterning method has been illustrated here using mainly photolithography, but by using masks, or the like, the fabrication may be carried out in such a way that the films are not deposited onto unnecessary parts from the beginning, and the production process is not limited in any way.

In this document reading device 116, since the lower electrode 120a is constructed from a metal layer 120a₁ and a transparent conductive layer 120a₂, an interface is formed at the junction of the semiconductor layer 120b with the transparent conductive layer 120a₂. It is thought that an electrical potential barrier, or a barrier such as trap levels arising from the diffusion of material constituting the transparent conductive layer 120a₂ into the semiconductor layer 120b is formed at this interface. Consequently, it is considered that the operation is similar to the above-mentioned document reading device 90, and as a result, a similar effect is obtained.

In order to confirm this kind of effect, a document reading device of the present embodiment was fabricated and an experimental comparison with the above-mentioned Comparative Example 1 was carried out.

### Example 2

A document reading device of the present embodiment was first fabricated using the method indicated as follows.

Using alkali-free glass (#7059) manufactured by Corning as a substrate 12, first a 1500 to 2000 Å thick chromium film and further a 600 Å thick ITO film were deposited onto this substrate 12 by DC sputtering. Specifically, the substrate 12 was set up in the chamber, and after evacuating the chamber to not more than 10⁻⁵ Torr, the substrate 12 was maintained at 100 to 250 °C, and by introducing argon gas and oxygen gas in a set ratio under a pressure of 0.1 to 1.0 Pa and DC electric power of 0.1 to 1.0 W/cm², a chromium film and an ITO film were deposited in sequence. Onto this was further deposited in sequence, in a similar manner to Example 1, a p-type, an i-type and an n-type amorphous silicon film, and then onto this was deposited an ITO film.

Then, in a similar manner to Example 1, the top-layer ITO film, the amorphous silicon film made of 3 layers, and the bottom-layer ITO film were patterned in the prescribed configuration, to form the upper electrodes 118c, 120c, the semiconductor layers 118b, 120b, and the transparent conductive layers 118a₂, 120a₂ which were parts of the lower electrodes 118a, 120a. Here, the transparent conductive layers 118a₂, 120a₂ which were parts of the lower electrodes 118a, 120a were formed by etching of the bottom-layer ITO film using the mixed solution of hydrochloric acid and nitric acid and with the resist used for the patterning of the upper electrodes 118c, 120c and the semiconductor layers 118b, 120b. Following this, after removing the resist used for the patterning, the chromium film was patterned in the prescribed configuration using photolithography, to form the metal layers 118a₁, 120a₁, which were parts of the lower electrodes 118a, 120a. Here, ceric ammonium nitrate was used for the etching of the chromium film.

In this way photodiodes 118 and blocking diodes 120 were fabricated, with the same number of diodes, the same constructions and the same sizes as in Example 1. Following this, in a similar manner to Example 1, an interlayer insulating film 96, coupling leads 100 and a protective film 104 were formed, to fabricate the document reading device.

Next, the document reading device obtained in this Example 2 and the document reading device obtained in the above-mentioned Comparative Example 1 were connected to drive circuits and signal processing circuits, and a document varying between white and black was read at a clock pulse frequency of 500 kHz and a reading speed of 5 milliseconds/line using an illumination intensity of 20 Lux. As a result, an output voltage Vout as shown in the above-mentioned Figure 15 was obtained from the signal processing circuit. Thus, a reverse after-image Vr appears in the output voltage Vout immediately after reading white, which causes black read immediately after reading white to become blacker than the normal black. However, the reverse after-image Vr of the example became smaller than the reverse after-image Vr of the comparative example, so that its converging time was also shortened. The results are collectively shown in Table 1. Here, the output voltage Vout corresponding to white was from 160 to 180 mV.

Now, in the document reading device of the present invention exemplified in the above-mentioned embodiment, the upper electrode 118c which constitutes the photodiode 118 and the upper electrode 120c which constitutes the blocking diode 120 are connected using a coupling lead 100. However, as shown in Figure 18, the lower electrode 122 which constitutes the photodiode 118 and the lower electrode 122 which constitutes the blocking diode 120 are common, so that the photodiode 118 and the blocking diode 120 may be connected using this lower electrode 122, to form a document reading device 124. In this case, a metal layer 126 and a transparent conductive layer 128 are deposited in sequence, to form the lower electrode 122, and the construction is carried out so that an interface is formed between the semiconductor layers 118b, 120b and the transparent conductive layer 128. Furthermore, the construction is carried out so that the upper electrode 118c of the photodiode 118 is led out using a lead-out conductor 130 through a contact hole 98, and is connected to the respective channel lead C₁, C₂,..., Cₙ through a contact hole 102, and on the other hand, the upper electrode 120c of the blocking diode 120 is led out to the exterior using a lead-out conductor 132 through a contact hole 98. In the present embodiment, the photodiode 118 and the blocking diode 120 are connected in series and opposite polarity with each other by connecting their anode electrodes together.

Here, in the embodiments shown in the above-mentioned Figures 17 or 18, either the metal layers 118a₁, 120a₁ and the transparent conductive layers 118a₂, 120a₂, or the metal layer 126 and the transparent conductive layer 128 have different configurations, but they may also have identical configurations.

Furthermore, in the above-mentioned embodiments, the anode electrodes or cathode electrodes of the blocking diodes 120 are connected commonly within each block B₁, B₂,..., Bₘ, and the anode electrodes or cathode electrodes of the photodiodes 118 in the same relative positions in the individual blocks B₁, B₂,..., Bₘ are connected together using the respective channel leads C₁, C₂,..., Cₙ; however, the photodiodes and the blocking diodes may have the reverse arrangement, in which the anode electrodes or cathode electrodes of the photodiodes are connected commonly within each block, and the anode electrodes or cathode electrodes of the blocking diodes in the same relative positions in the individual blocks are connected together using the respective channel leads. That is to say, the photosensor elements formed from the photodiodes (photoelectric energy converting elements) and the blocking diodes (switching elements) are divided every set number of elements into a plurality of blocks in a one-dimensional multiple array, in which the photosensor elements should be connected commonly on any one side within each block, and those in the same relative positions in the individual blocks should be connected together commonly on the other side using the respective channel leads.

Furthermore, in the above-mentioned embodiments, since for reasons such as the simplification of the production steps, the respective lower electrodes 118a, 120a, semiconductor layers 118b, 120b and upper electrodes 118c, 120c which constitute the photodiode 118 and the blocking diode 120 are deposited simultaneously, they are composed of the same respective materials; however, the upper electrode 118c which constitutes the photodiode 118 must be transparent, but the upper electrode 120c which constitutes the blocking diode 120 need not be transparent. Furthermore, the lower electrode 118a which constitutes the photodiode 118 need not be constructed from a metal layer and a transparent conductive layer, but at least the lower electrode 120a which constitutes the blocking diode (switching element) 120 should be constructed from a metal layer 120a₁ and a transparent conductive layer 120a₂. In other words, the present invention should prevent the occurrence of a reverse direction current in the switching element by forming an interface between the transparent conductive layer and the semiconductor layer which constitute the switching element. Here, the metal layer may be one layer, but it may also be not less than 2 layers.

In the above, the semiconductor devices of the present invention have mainly a pin structure of layers stacked in sequence from the substrate 12, but the layers may be stacked in the reverse order of nip, to give an nip structure. Here, the lower electrode or upper electrode comprising a transparent conductive layer is preferably constructed in contact with the p sublayer of the semiconductor layer. Furthermore, in addition to the above-mentioned pin type, the semiconductor layer may be an ni type, pi type, pn type, MIS type, heterojunction type, homojunction type, Schottky barrier type or combinations thereof, and so forth, deposited as single layers or multilayers. Moreover, for the amorphous silicon which constitutes the semiconductor layer, hydrogenated amorphous silicon a-Si:H, hydrogenated amorphous silicon carbide a-SiC:H, amorphous silicon nitride or the like, or simply amorphous silicon or the like are preferred, but deposited materials such as either microcrystalline or amorphous silicon semiconductors made of alloys of silicon with other chemical elements such as carbon, germanium or tin may be used, and there is no limitation on these structures. Moreover, the semiconductor layer applicable to the present invention is not limited to amorphous or microcrystalline, but may also be single-crystal.

In addition, the photoelectric energy converting element may be not only a photovoltaic-type element such as a photodiode, but may also be a photoconductive-type element. Furthermore, within the scope of the present invention and without deviating from its spirit, various kinds of additional improvements, revisions and modifications, such as the use of a TFT or the like for the switching element, are possible by the intelligence of one skilled in the art.

### Potential for Industrial Application

In the semiconductor device made of a semiconductor element having a switching function of the present invention, since at least one of the lower electrode and the upper electrode are composed of a transparent conductive layer, an interface is formed between the semiconductor layer and the transparent conductive layer, with the result that, by the barrier formed at this interface, the reverse direction current is rapidly converged and its peak value becomes small. As a result of this, the switching rate is sharply increased. Here, it is thought that light which leaks from the periphery is transmitted through the transparent lower electrode or upper electrode and enters the semiconductor layer, so that the reverse direction current is rapidly converged and its peak value becomes small.

In the photosensor element made of a photoelectric energy converting element and a semiconductor element having a switching function which is a semiconductor device of the present invention, since at least one of the lower electrode and the upper electrode which constitute at least the switching element is composed of a transparent conductive layer, an interface is formed between the semiconductor layer and the transparent conductive layer, with the result that, by the barrier formed at this interface, the reverse direction current is rapidly converged and its peak value becomes small. As a result of this, a more precise signal output is obtained and the switching rate is improved. Here, it is thought that light which can leak from the periphery enters the semiconductor layer which constitutes the switching element, so that both the reverse direction current is rapidly converged and its peak value becomes small.

Moreover, in the document reading device which is a semiconductor device of the present invention, since at least one of the lower electrode and the upper electrode which constitute at least the switching element are composed of a transparent conductive layer, an interface is formed between the semiconductor layer and the transparent conductive layer, with the result that by the barrier formed at this interface, the reverse direction current is rapidly converged and its peak value becomes small, so that the switching rate of the switching element is improved. As a result of this, the reverse after-image is reduced and a precise signal output can be obtained. In particular, this is advantageous in the case when document reading is performed under low illumination intensity, so that lowering of the electrical power consumption, and so forth, can be promoted. Moreover, it is also possible to sharply increase the signal reading speed. Here, it is thought that light which leaks from the periphery enters the semiconductor layer which constitutes the switching element, so that the reverse saturation current is rapidly converged and its peak value becomes small, and as a result, the switching rate of the switching element is improved. Thus, the present invention performs various kinds of outstanding effects.

## Claims

1. A semiconductor device provided with one or a plurality of a semiconductor element having a switching function, said semiconductor element comprising the stacking in order of a lower electrode, a semiconductor layer and an upper electrode,
characterized in that at least one of the said lower electrode and upper electrode comprises one or not less than two conductive layers and at least the conductive layer contacting the semiconductor layer comprises a transparent conductive layer.

2. A semiconductor device provided with one or a plurality of a photosensor element, wherein the photosensor element comprises the semiconductor element having the switching function of claim 1 connected in series with a photoelectric energy converting element, said photoelectric energy converting element comprising the stacking in order of a lower electrode, a semiconductor layer and an upper electrode.

3. A semiconductor device comprising the photosensor element which comprises the semiconductor element having the switching function of claim 1 connected in series with the photoelectric energy converting element, said photoelectric energy converting element comprising the lower electrode, the semiconductor layer and the upper electrode, wherein the photosensor elements are, in a one dimensional multiple array, divided every set number of elements into a plurality of blocks,
in which the photosensor elements are connected commonly on any one side within each block, and the photosensor elements in the same relative positions in the individual blocks are connected together commonly on the other side using channel leads.

4. The semiconductor device of any one of claims 1 to 3, characterized in that, at the least, in the semiconductor device provided with one or a plurality of said semiconductor element having the switching function, at least one of the lower electrode and the upper electrode of the semiconductor element comprises a transparent conductive layer.

5. The semiconductor device of any one of claims 1 to 4, characterized in that, at the least, in the semiconductor device provided with one or a plurality of said semiconductor element having the switching function, the transparent conductive layer of the semiconductor element comprises ITO.

6. The semiconductor device of any one of claims 1 to 5, characterized in that, at the least, in the semiconductor device provided with one or a plurality of said semiconductor element having the switching function, among the semiconductor layers of the semiconductor element, at least the semiconductor layer contacting the transparent conductive layer is a p-type semiconductor layer.

7. The semiconductor device of any one of claims 1 to 6, characterized in that, at the least, in the semiconductor device provided with one or a plurality of said semiconductor element having the switching function, the semiconductor layers of the semiconductor element comprise hydrogenated amorphous silicon deposited sequentially by plasma CVD and are a pin structure.

8. The semiconductor device of any one of claims 2 to 7, wherein the said semiconductor element having the switching function and the said photoelectric energy converting element are each provided with diode properties and their cathode electrodes are connected with each other in series.

9. The semiconductor device of any one of claims 2 to 8, wherein the respective lower electrodes, semiconductor layers and upper electrodes comprising said semiconductor element having the switching function and said photoelectric energy converting element are deposited simultaneously.

10. The semiconductor device of any one of claims 2 to 9, characterized in that in the semiconductor device provided with one or a plurality of the photosensor element comprising said semiconductor element having the switching function connected in series with said photoelectric energy converting element, whichever one of the lower electrode and the upper electrode is positioned on the opposite side to the light entrance side at least comprises a transparent conductive layer in contact with the semiconductor layer.
